# EUROPEAN PATENT APPLICATION

(11) **EP 4 741 853 A1**
(43) Date of publication of application: **13.05.2026**
(21) Application number: 25213696.5
(22) Date of filing: 05.11.2025
(51) Int. Cl.: G01R 31/389, G01R 31/396

(54) **ELECTROCHEMICAL IMPEDANCE SPECTROSCOPY SYSTEM AND METHOD**

(30) Priority: 06.11.2024 EP 24383213; 29.04.2025 EP 25382430
(71) Applicant: Ficosa Automotive, S.L.U., 08232 Viladecavalls (ES)
(72) Inventor: BAUTISTA FLORENSA, Roger, 08232 Viladecavalls (Barcelona) (ES); GÓMEZ NÚÑEZ, Alberto, 08232 Viladecavalls (Barcelona) (ES)
(74) Representative: Bardehle Pagenberg S.L.

(57) **Abstract**

An electrochemical impedance system comprising a vehicle battery, a battery management system (BMS), an excitation power module, and a current sensor. The vehicle battery comprises, in turn, one, two or more battery modules. Each battery module includes a plurality of battery cells. The BMS is configured to control the excitation power module to excite at least the one, two or more battery modules. The current sensor is configured to sense at least electric current of the one, two or more battery modules. The BMS is further configured to sense, determine, or receive voltage of the plurality of battery cells of the one, two or more battery modules, and also receive the electric current of the one, two or more battery modules sensed by the current sensor. In this way, the system of the present disclosure is capable of determining the electrochemical impedance of the vehicle battery. The corresponding method is also provided.

## Description

### FIELD OF TECHNOLOGY

The present application relates an electrochemical impedance spectroscopy system. The electrochemical impedance spectroscopy system is configured to determine an electrochemical impedance of a vehicle battery. For this, the system is provided with a battery management system that controls an excitation power module configured to excite the vehicle battery. The system may be further configured to generate a battery cell degradation output based at least on the determined impedance. The corresponding method is also provided.

### BACKGROUND

Electric vehicles have at least an electric motor and a vehicle battery. In operation, the electric motor is adapted to provide propulsion to the vehicle, e.g., to drive the transmission connected to the vehicle wheels. Electric vehicles may be pure electric vehicles, only-electric vehicles or all-electric vehicles. Electric vehicles may also include hybrid electric vehicles which combines a conventional internal combustion engine system with an electric propulsion.

Different types of batteries are used to power electric motors. Lithium-ion batteries are the most utilized technology in electric vehicles. However, other types of vehicle batteries are known. In any case, it is of vital importance to operate vehicle batteries in pre-defined safety limits to ensure the safety of the user as well as the electric vehicle.

In use, vehicle batteries suffer from aging, wearing, or degradation. The monitoring and control of (high-voltage) vehicle batteries in electric vehicles throughout their lifespan aim to maximize efficiency while extending their remaining useful life.

The state of health or SOH of a vehicle battery refers to a measure of the current condition or performance of the vehicle battery compared to its ideal or original state when it was new. SOH is typically expressed as a percentage, where 100% indicates a vehicle battery that is in perfect condition, and lower percentages represent aging, wear, or degradation. In fact, SOH helps in assessing the remaining useful life of the vehicle battery and indicates when it may need replacement or maintenance.

Improvement and optimization of energy management and the enhancement of battery lifespan are crucial topics in the automotive industry. Recent innovations in computation and electronics present remarkable advances for implementation in battery control. The use of novel artificial intelligence and other predictive models can contribute to improving the precision of battery state estimations. The remaining useful life of the battery is closely related to the SOH.

Additionally, battery degradation can result in hazardous events, with thermal runaway being the most well-known. The state of safety or SOS of a vehicle battery refers to the assessment of the battery's safety status, ensuring it operates without posing risks such as fire, explosion, leakage, or other hazardous conditions. SOS evaluates the vehicle battery's ability to function safely under normal and stressful conditions, including temperature extremes, overcharging, physically damage, and other environmental factors. Thus, monitoring the SOS is also a prominent indicator to consider in the technological field of electric vehicles.

The state of charge or SOC may be defined as an indication of the current charge level of the vehicle battery, typically as a percentage, showing how much energy is available for use. Existing algorithms yield remarkable results in estimating the SOC; however, the SOH requires more complex algorithms, and the SOS is still challenging to calculate for electric vehicle batteries.

In known prior art, algorithms used in battery management systems for SOH and SOS rely on measured signals from the vehicle battery. Particularly, known battery management systems utilize direct measurements, such as voltage, electric current, and temperature, to calculate these indicators. However, the accuracy of these calculations depends on the performance of the underlying algorithms.

It would be therefore desirable to provide a system and method for determining an electrochemical impedance of a vehicle battery in order to obviate the above-mentioned drawbacks and to provide advantageous solutions to the shortcomings in the prior art.

### SUMMARY

It is an object of the present invention to provide an electrochemical impedance spectroscopy system configured at least to determine an electrochemical impedance of a vehicle battery. The electrochemical impedance spectroscopy system is referred hereinafter as the system for clarity and conciseness reasons.

The system comprises a vehicle battery, a battery management system or BMS. A plurality of voltage sensors may be further provided preferably as part of the battery management system. The system further comprises an excitation power module, and a current sensor.

The vehicle battery is arranged within a motor vehicle (for driving the motor(s) configured) to move the wheels thereof as required. The vehicle battery may be a high-voltage battery used in electric vehicles and hybrid vehicles. The vehicle battery may operate with a voltage higher than 100 volts, for example, within a voltage range of 200 volts to 1000 volts. The exact voltage depends on the vehicle type and the manufacturer's design. In fact, the vehicle battery is a rechargeable battery used to supply electric power to electric vehicle, e.g., to an electric power operated system (explained further below). The primary function of the vehicle battery is to provide the necessary electric power to the electric power operated system, e.g., to the traction system. Furthermore, the vehicle battery may also power low voltage systems that may include auxiliary electrical components such as lights, infotainment systems, and sensors.

The vehicle battery comprises one, two or more battery modules. Each battery module includes a plurality of battery cells. That is, the vehicle battery comprises at least one battery module, i.e., a first battery module. Said first battery module includes a plurality of battery cells arranged one next to the other. The vehicle battery may preferably comprise a second battery module that, in turn, may include a plurality of battery cells arranged one next to the other. A third battery module and further battery modules may be of course provided in the vehicle battery.

Each of the plurality of voltage sensors may be electrically connected to the one, two or more battery modules (i.e., at least to the first and/or second battery modules). Each voltage sensor may be configured to sense at least voltage of one or more battery cells (e.g., a group of battery cells). The battery management system may comprise a cell monitoring controller or CMC that may include said plurality of voltage sensors.

The excitation power module also referred herein as EIS excitation generator (or excitation power converter) is electrically connected to the vehicle battery (e.g., to the one, two or more battery modules) and the battery management system. The excitation power module may be configured to excite at least the one, two or more battery modules. That is, the excitation power module may generate electric power with a non-constant current perturbation to be received by the battery cells. For this, the battery management system is configured to control the excitation power module as required.

The current sensor may be configured to sense at least electric current of the one, two or more battery modules (i.e., at least to the first and/or second battery modules). The current sensor may be connected to the one, two or more battery modules (i.e., at least to the first and/or second battery modules).

As explained above, the system is configured at least to determine the electrochemical impedance of the vehicle battery. The electrochemical impedance of the vehicle battery refers to the opposition that a battery's electrochemical structure presents to the flow of alternating current over a range of frequencies. It combines both resistive and reactive components of the vehicle battery's internal resistance and provides insights into different processes occurring within the vehicle battery, such as charge transfer, diffusion, and double-layer capacitance. That is, the system is configured to perform the electrochemical impedance spectroscopy to determine the internal impedance value of the system, in this specific application, battery cells. The impedance of the battery cells has resistance and reactance values, in consequence, the impedance is a complex value. To calculate it, electric current and voltage through the battery cell are measured and then Ohm's Law is applied to calculate impedance's magnitude and the phase is obtained from phase variations. The determination of the electrochemical impedance may be conducted under a potentiostatic technique or a galvanostatic technique.

The potentiostatic mode or technique comprises applying a constant direct-current potential with a superimposed non-constant (or alternate-current / sine-wave) perturbation. The input or excitation input signal is the potential (or voltage) and the resulting current response is measured, both measured with sensors.

The galvanostatic mode or technique comprises applying a constant current with a small non-constant current perturbation. **In** this case, the excitation input signal is the current and the resulting voltage response is measured.

For determining the impedance, the system requires to study a frequency spectra analysis of the impedance so as to determine the reactance value of the battery cell. Therefore, the system involves low-frequency to high-frequency (e.g., 0.1 - 4000 Hz) voltage and current signals. The excitation input signal is expected to be non-constant, which ideally, should be a sine-wave. However, if a frequency analysis is conducted from the measured signals, other non-continuous signals can be applied, such as square-wave.

The (current or voltage) excitation input signal (galvanostatic or potentiostatic mode) is controlled by the battery management system. The excitation input signal may be generated with a unique excitation input signal for the one, two or more battery modules. The voltage perturbation response may be measured at the plurality of battery cells level, wherein the current perturbation response may be measured at the two or more battery modules level in order to have a successful characterization of the impedance of the plurality of battery cells. The measured signal generally goes to an analog-to-digital interface to be then processed to calculate the impedance. **In** any case, the excitation signal though the battery cell may be small enough to not modify the battery cell conditions, alike the state of charge.

Battery cells are inherently non-linear systems; however, impedance can only be defined or calculated for linear systems. The impedance of a cell may be approximated if linear timeinvariant conditions are assumed. Linearization of such a system requires the following:
- Causality: The system's response to perturbation must be generated solely as a result of the applied perturbation or excitation signal.
- Linearity: The relationship between perturbation and response must adhere to linear differential laws.
- Stationarity: The system should exhibit minimal variation with respect to environmental conditions, specifically the state of charge, temperature, and voltage level of the cell.
- Stability: The system must remain stable over time, meaning it should return to its initial state once the perturbation is removed.

The battery management system or BMS is electrically connected to the vehicle battery. In fact, the battery management system is configured at least to control the vehicle battery. The BMS may be responsible of the data and signal acquisition from the vehicle battery and perform, at least, a basic control including direct operation over battery pack components and communicate with other controllers. For example, the BMS is configured to receive multiple measurements of the vehicle battery including at least one of: current, cell voltages, and one or more temperatures. Additionally, the BMS may receive measurements such as gas (e.g., H2, CO, CO2), pressure, isolation and leakage. The BMS processes these values which can be transmitted to an external controller such as a vehicle controller through bus communication channels. Additionally, these measurements (or instructions or commands) received by the bus communication channel may be used by the BMS to directly operate battery pack components alike junction-box contactors / relays, operate thermal management system, balance battery cells or calculate estimation parameters of the battery status alike state of charge (SOC) or state of health (SOH).

**In** use, the battery management system is configured to particularly sense or determine voltage of the plurality of battery cells of the one, two or more battery modules (i.e., at least to the first and/or second battery modules). Also, the battery management system is configured to receive the electric current of the one, two or more battery modules (i.e., at least to the first and/or second battery modules) sensed by the current sensor.

Thanks to the present system, the impedance of the plurality of battery cells may be calculated, estimated or determined derived at least in part from the electric current and the voltage. There may be two options to determine the impedance of the plurality of battery cells:
FIRST: the battery management system is configured to determine the impedance of the plurality of battery cells of the one, two or more battery modules based at least on the electric current and the voltage.
SECOND: the battery management system is configured to send the electric current and the voltages to the external controller configured to determine the impedance of the plurality of battery cells of the one, two or more battery modules based at least on the electric current and the voltage(s).

The system may be further configured to monitor an electrochemical degradation of the battery cell by determining the impedance variation compared to one or more previous measurements. **In** fact, an outcome of the electrochemical impedance spectroscopy may be to monitor the degradation of the battery cells and also may be used to detected hazardous events such as an early-warning of a thermal runaway.

**In** any case, a preliminary analysis or study of the battery cell impedance at beginning of life is to be conducted. To enable this analysis, a data set is available, obtained through prior aging tests in which the impedance data is determined at each stage. This approach allows calculation of the degradation status of the cell over its lifecycle within the vehicle. Then, the electrochemical impedance spectroscopy results may be compared to the one or more previous measurements and the impedance variations may be used to determine a more precise real-time battery estimation values for example.

A preliminary analysis or study of the battery cell impedance at the beginning of life may be performed. To enable this analysis, a data set is available, obtained through prior aging tests in which the impedance data is determined at each stage. This approach allows calculation of the degradation status of the cell over its lifecycle within the vehicle.

The precision of the impedance results depends on the voltage and current sensors. The resolution and accuracy of the measurements may preferably be according to the requirements of the Kramers-Kronig conditions, to ensure the cell linear response and the stable conditions. Thus, if a small amplitude perturbance response is expected, the resolution of the sensor is to be dimensioned accordingly because the phase difference detection precision is crucial to measure the impedance.

It is preferred that the current sensor is a single current sensor electrically, i.e., a single unit current sensor. The current sensor is configured to sense at least electric current of the two or more battery modules (at least to the first and second battery modules). For this, the current sensor may be connected (directly or indirectly) to two or more battery modules (at least to the first and second battery modules). The reason to use one single current sensor is because the vehicle-battery configuration is known in advance. If all the battery cells are connected in a series group, the current at each is the one measured. If parallel groups exist, an assumption of equivalent load distribution can be performed. If there exist imbalances, the measured voltages may present different voltage responses for a whole parallel group. The use of one single current sensor for the electrochemical impedance spectroscopy may contribute in a cost reduction of the solution with a simplified solution where the current measurement may be used (at the same time) for both power converter in its control loop, and in the BMS for the impedance calculation.

The current sensor may be electrically arranged therebetween the excitation power module and the vehicle battery. The term 'therebetween' is to be understood such that the current sensor may be included in the excitation power module or in the vehicle battery. It is thus possible that the current sensor may be (physically) arranged within the battery management system, a junction box (explained below), or the electric power operated system. If the current sensor is arranged in the junction box, it may be part of the electric circuit of the junction box that receives/supplies high electric power (explained further below). Alternatively, if the current sensor is arranged in the electric power operated system or in the junction box, it may not be part of the electric circuit of the electric power operated system that receives/supplies high electric power. What is important is that the current sensor is in electrical connection with the electric connecting means adapted for connecting the excitation power module with the vehicle battery, regardless of its physical location.

Preferably, the excitation power module is a single excitation power module. In operation, the excitation power module is configured to excite at least two or more battery modules (the first and/or second battery modules) such as all battery modules.

It may be preferred that the excitation power module is arranged out of the vehicle battery and the battery management system. Alternatively, the excitation power module may be arranged in the junction box (in a separate electric circuit from the contactors), or in the on-board charger being an independent module from the power train (i.e., the traction system).

The excitation power module, the vehicle battery, the current sensor, and the battery management system form an electric circuit that may be electrically independent of the electric power flowing through the junction box and/or the electric power operated system received at least by the traction system.

The electric power operated system may be at least one of air conditioning system, low voltage system, an on-board charger or OBC, and a traction system (i.e., vehicle propulsion system). The traction system may include an electric power train also known as the electric motor. In particular, the electric power operated system may be provided with or connected to multiple devices. Additionally, when parking/stopped mode is expected, the junction box contactors or relays may be open, then, the vehicle battery may be isolated to perform the electrochemical impedance spectroscopy where stable conditions are ensured. If the driving mode is activated, the contactors or relays of the junction box may be closed allowing at least the traction system receiving electric power from the vehicle battery.

The present invention differentiates from most prior art in that the procedure to execute current and voltage measurements for impedance calculation and characterization is not defined at vehicle scale considering the different elements located in the vehicle that must participate to succeed in the impedance measurement. Therefore, the present invention requires controlling the battery connection system, including the junction-box contactors, the HV bus measurements including HV voltage and HV current, enabling the synchronization between cell voltages and battery current and the acceptance and following data processing of the BMS and other ECUs.

It is preferred that the battery management system is configured to receive a vehicle input signal. The battery management system is also configured to determine a trigger command of the system based at least on the vehicle input signal. The vehicle input signal is at least related to vehicle status and the vehicle-battery status.

The vehicle status is at least one of parking mode, ignition off, vehicle not started. Further, the vehicle-battery status comprises whether the vehicle battery receives and/or supplies electric power or not. Stability and linearity conditions in the vehicle battery can be ensured.

Preferably, the battery management system is further configured to receive or generate a starting instruction. In this way, the trigger command of the system is based on the starting instruction.

In turn, the starting instruction is based at least on one predefined event, such as a predefined time, predefined distance, and an instruction from the user or driver.

Preferably, the trigger command of the system is further based on a temperature of the vehicle battery and/or pre-set time. More preferably, the trigger command is delayed by the pre-set time or up to the temperature of the vehicle battery is lower than a pre-established temperature.

It is preferred that the vehicle input signal is received from an external controller. For example, the external controller may be arranged out of the system. Alternatively, the vehicle input signal is received (directly) through a vehicle communication channel such as a CAN-BUS communication.

Preferably, the battery management system or the external controller is configured to receive a change of the vehicle status (e.g., parking mode) or the vehicle-battery status (e.g., the electric power supplied by the vehicle battery is changed). In the event of change in the vehicle status and/or the vehicle-battery status, the battery management system or the external controller may be configured to stop determining the impedance.

The trigger command of the system may be further based on a cell balancing of the vehicle battery to ensure stable conditions. Optionally, the trigger command is delayed up to the cell balancing is completed. This ensures that all battery cells are at the same voltage level and that the impedance measurement will be uniform.

In use, the present system or the external controller (with embedded algorithms) is further configured to generate a battery cell degradation output based at least on the determined impedance. Said (embedded) algorithms may comprise an artificial intelligence module such as a trained machine learning. Alternatively, it may be a data analysis or data correlation system. Along their lifespan, the battery cells degrade losing some electrochemical properties. The degradation of the cells impacts the remaining useful life of the battery and the vehicle. If this smooth degradation is monitored the energy management of the vehicle may be tuned towards an optimized and more efficient energy usage. Additionally, the electrochemical impedance spectroscopy results can be used for forensic analysis; in case of an accident, checking the battery status; or for second-life use, determine the status of the battery and consider the application that better suits to it.

It is preferred that the excitation power module comprises an energy accumulator, and an energy modulator. In use, the energy accumulator may be configured to store electric power to be provided to the energy modulator. Instead, the energy modulator may be configured to generate a (variable) excitation current signal to the vehicle battery. The excitation current signal is thus responsible for the excitation power module (e.g., the energy modulator) to excite (at least) the (one,) two or more battery modules, thereby allowing the (single) current sensor to sense at least electric current of the (one,) two or more battery modules when excited. The variable excitation current signal to the vehicle battery may be understood as a non-constant electrical signal that exhibits variation over time, which may be periodic or non-periodic in nature. Examples of such signals include, but are not limited to, sinusoidal waveforms, multisine signals, square waves, triangular waves, or binary pulse sequences. The signal is configured to enable a frequency-domain decomposition, i.e., it comprises frequency components different from zero, allowing analysis of the battery's impedance as a function of frequency.

The system may further comprise a first switching device connected to the vehicle battery. The first switching device may be configured to switch between an open position to a close position. Further, the energy modulator may be associated with the first switching device.

During operation of the excitation power module, the first switching device is in the open position.

When the first switching device is in the open position, the vehicle battery is electrically isolated, or the EIS system is in operation. When the first switching device is closed, the vehicle battery may supply electric power e.g., to the electric motor.

The system may further comprise a second switching device connected to the vehicle battery. The second switching device may be configured to switch between an open position to a close position. Further, the energy modulator may be associated with the first switching device and the second switching device. During operation of the excitation power module, the first switching device is in the open position and the second switching device is in the closed position.

When both (first and second switching devices) are open, the vehicle battery is electrically isolated. When both (first and second switching devices) are closed, the vehicle battery may supply electric power e.g., to the electric motor. During operation of the excitation power module, the first switching device is in the open position, and the second switching device is in the closed position.

Further, in the present disclosure, the first and/or second switching devices may be an electronic device such as a transistor, or an electromechanical device, such as a contactor or a relay.

The excitation power module and the vehicle battery are electrically connected to each other at least through a first conductor, and a second conductor. The first and second conductors are connected to the terminals of the vehicle battery. Preferably, the first switching device may be connected to the first conductor, and the second switching device may be connected to the second conductor. Particularly, the first conductor and the second conductor are configured to be connected to the positive and negative terminals of the vehicle battery, respectively. That is, the first conductor is a positive electric cable, wire or (bus)bar. Similarly, the second conductor is a negative or ground electric cable, wire or (bus)bar. In any case, the second conductor may optionally be at a lower electrical potential than the first conductor, when connected to the respective terminals of the vehicle battery.

The system may further comprise a switching device controller. The switching device controller may be configured to control the open and closed positions of the first switching device and the second switching device.

It is preferred that the first switching device defines a first side and a second side. The first side is arranged between the energy accumulator and the first switching device. Instead, the second side is arranged between the first switching device and the vehicle battery.

The energy modulator may preferably comprise a first branch, and a second branch, wherein the first branch is electrically connected to the second branch. The first branch is (directly) electrically connected to the first side of the first switching device, and the second branch is (directly) electrically connected to the second side of the first switching device.

Also, the energy modulator may further comprise a third branch. The third branch is (directly) electrically connected to the first and second branches when provided. In operation, the third branch is electrically connected to either side of the second switching device. In other words, the third branch may be (directly) electrically connected to a first side or a second side of the second switching device. The first side of the second switching device is arranged between the energy accumulator and the second switching device, wherein the second side of the second switching device is arranged between the second switching device and the vehicle battery.

A branch (i.e., the first, second, and third branch) refers to a path or line that conducts current between two points in a circuit (e.g., to the first and/or second conductor). A branch may consist of a single electrical line or comprise two or more electrical lines. In either case, each line or path preferably includes one or more electrical components.

The energy modulator may comprise an inductor, a resistor, and/or a capacitor. The inductor, the resistor, and/or the capacitor may form a current and/or voltage filter. The inductor, the resistor, and/or the capacitor may be associated with the second branch. Preferably, the second branch comprises the inductor, the resistor, and/or the capacitor, e.g., attached to the junction box. In any case, the inductor may be configured to store energy, e.g., in a magnetic field, when electric current flows through it. The inductor may thus be configured to receive electrical energy from a power supply external to the junction box, such as from a DC-link capacitor or a DC converter, and to accumulate electrical energy while reducing voltage ripple, thereby ensuring a smoother and more stable power supply to the vehicle battery, which is particularly beneficial for enabling accurate electrochemical impedance spectroscopy (EIS) measurements. In fact, less signal filtering is required and the current control loop does not present heavy spikes that could make the system uncontrollable. It is absolutely possible for the second branch to further include one or more electronic components such as an additional resistor, an additional capacitor, and/or an additional inductor. If the second branch includes one or more additional capacitors and/or one or more additional inductors, a filter may be formed to reduce voltage ripple, such as a resonant filter.

It is preferred that the energy modulator comprises a first semiconductor switch. It is even more preferred that the first semiconductor switch is (operatively) associated with the first branch. More preferably, the first branch comprises the first semiconductor switch. For example, the first semiconductor switch may be a controllable transistor such as a MOSFET or an IGBT (Insulated Gate Bipolar Transistor). As the first semiconductor switch can be controlled to open and close, the energy modulator is capable of producing the variable excitation signal for enabling accurately electrochemical impedance spectroscopy (EIS) measurements.

Preferably, the energy modulator may further comprise a first anti-series semiconductor switch. More preferably, the first anti-series semiconductor switch is (operatively) associated with the first branch and connected in series with the first semiconductor switch. In use, the conduction path of the first anti-series semiconductor switch is arranged in an opposite direction to the conduction path of the first semiconductor switch. The first anti-series semiconductor switch is in an open state when the EIS system is not in operation, and in a closed state when the EIS system is in operation, thereby allowing electric current to pass through. In this way, the first anti-series semiconductor switch ensures that reverse current is prevented when the EIS system is not in operation. Accordingly, the first anti-series semiconductor switch remains open when the EIS system is not in operation. Upon operation of the EIS system, the first anti-series semiconductor switch transitions to a close state (e.g., without operating in a PWM (pulse-width modulation) mode), allowing bidirectional current flow. Subsequently, the first semiconductor switch begins switching operations (i.e., switching between open and close positions).

By enabling control over the open and closed states of the first anti-series semiconductor switch, it is possible to prevent short circuits in the vehicle battery. Specifically, when the first anti-series semiconductor switch is open, current is blocked due to the presence of the reverse diodes of both the first anti-series and the first semiconductor swich, which collectively oppose and thereby negate any potential current paths. This arrangement also enables safe disconnection of the EIS system in the event of an overcurrent condition, mitigating the risk of damage to system components. For example, the first anti-series semiconductor switch may be a controllable transistor such as a MOSFET.

It is preferred that the energy modulator may comprise a second semiconductor switch. The second semiconductor switch may be (operatively) associated with the third branch. More preferably, the third branch comprises the second semiconductor switch. For example, the second semiconductor switch may be a controllable transistor, such as a MOSFET or an IGBT (Insulated Gate Bipolar Transistor). The provision of the third branch with the second semiconductor switch enables improved regulation of the excitation current signal delivered to the vehicle battery. In particular, as the third branch is associated with the second terminal of the vehicle battery. It allows for the generation and handling of a variable excitation signals, such as alternating signals including both positive and negative components; that is, it allows the system to generate bidirectional currents and/or signals (i.e., both positive and negative). Particularly, the second semiconductor switch is in the open position when the first semiconductor switch is in the closed position (at least at a given instant). Similarly, the second semiconductor switch is in the closed position when the first semiconductor switch is in the open position (at least at a given instant).

Preferably, the energy modulator may comprise a second anti-series semiconductor switch. The second anti-series semiconductor switch may be (operatively) associated with the third branch and connected in series with the second semiconductor switch. In use, the conduction path of the second anti-series semiconductor switch is arranged in an opposite direction to the conduction path of the second semiconductor switch.

Preferably, the energy modulator may further comprise a second anti-series semiconductor switch. More preferably, the second anti-series semiconductor switch may be (operatively) associated with the third branch and connected in series with the second semiconductor switch. In use, the conduction path of the second anti-series semiconductor switch is arranged in an opposite direction to the conduction path of the second semiconductor switch. The second anti-series semiconductor switch is in an open state when the EIS system is not in operation, and in a closed state when the EIS system is in operation, thereby allowing electric current to pass through. In this way, the second anti-series semiconductor switch ensures that reverse current is prevented when the EIS system is not in operation. Accordingly, the second anti-series semiconductor switch remains open when the EIS system is not in operation. Upon operation of the EIS system, the second anti-series semiconductor switch transitions to a close state (e.g., without operating in a PWM mode), allowing bidirectional current flow. Subsequently, the first semiconductor switch begins switching operations (i.e., switching between open and close positions).

By enabling control over the open and closed states of the second anti-series semiconductor switch, it is possible to prevent short circuits in the vehicle battery. Specifically, when the second anti-series semiconductor switch is open, current is blocked due to the presence of the reverse diodes of both the second anti-series and the second semiconductor swich, which collectively oppose and thereby negate any potential current paths. This arrangement also enables safe disconnection of the EIS system in the event of an overcurrent condition, mitigating the risk of damage to system components. For example, the second anti-series semiconductor switch may be a controllable transistor such as a MOSFET.

The energy modulator may comprise two or more semiconductor switches (i.e., the first and second semiconductor switches explained above) so as to form at least a two-quadrant topology (i.e., a half bridge). In use, it enables at least bidirectional current flow so as to modulate the excitation current signal. Furthermore, the energy modulator may comprise at least two additional semiconductor switches (i.e., a third and a fourth semiconductor switch) so as to form a four-quadrant topology (i.e., full bridge or H bridge). That is, the energy modulator may comprise four or more semiconductor switches (i.e., the first, second, third and four semiconductor switches) controlled in such a way that at least bidirectional current flow and bidirectional voltage is enabled so as to modulate the excitation current signal.

It is preferred that one or more semiconductor switches (e.g., the first, second, third, and/or fourth semiconductor switches) is/are controlled via a PWM (Pulse-Width Modulation) switching signal. The semiconductor switches are preferably configured to operate at high switching speeds in order to generate the desired variable excitation current signal. The PWM switching signal enables the precise and rapid switching required to achieve such high-frequency modulation, thereby allowing effective regulation of the voltage and/or current delivered to perform the operation of the electrochemical impedance spectroscopy (EIS) system.

The electrochemical impedance spectroscopy system may further comprise a semiconductor switch controller. The semiconductor switch controller may be configured to control the open and closed positions of the one or more semiconductor switches (e.g., first / second / third / fourth semiconductor switches).

The semiconductor switch controller may be operatively connected to the one or more semiconductor switches, e.g., arranged in the half-bridge or full-bridge topology. The semiconductor switch controller may thus be configured to generate and transmit control switching signals, such as Pulse-Width Modulation (PWM) switching signals, to selectively open and close the semiconductor switches.

In the half-bridge configuration, the semiconductor switch controller alternately drives two semiconductor switches (e.g., the first and second semiconductor switches), wherein one semiconductor switch (e.g., the first semiconductor switch) is connected to the above-mentioned first conductor (e.g., a positive voltage supply) and the other to the second conductor (e.g., ground or negative). By modulating the duty cycle of the PWM signal applied to each semiconductor switch, the semiconductor switch controller can generate a variable voltage at the output node, preferably between 0 V and the reference voltage. This allows controlled delivery of the excitation current signal to the vehicle battery, thereby facilitating improved EIS measurements.

**In** the full-bridge configuration, the semiconductor switch controller drives four semiconductor switches arranged in two complementary pairs. By selectively activating diagonal pairs of switches in alternating patterns and adjusting at least the duty cycle of the switching signals, the semiconductor switch controller can generate a bidirectional variable electric signal across the vehicle battery. This configuration enables the creation of an alternating signal (e.g., bipolar PWM waveform) that may vary in amplitude, polarity, and frequency depending on the application requirements.

Through this controlled switching process, the semiconductor switch controller enables precise regulation of energy flow and waveform characteristics (i.e., the excitation current signal), which may be used as an injected diagnostic signal for operating the electrochemical impedance spectroscopy (EIS) system, thereby enabling accurate EIS measurements.

For the operation of the EIS system, the switching device controller may instruct the (e.g., second) switching device that is arranged opposite the inductor to be in the closed position, and the (e.g., first) switching device that is associated with the inductor to be in the open position. Furthermore, the semiconductor switch controller may instruct the (e.g., first) semiconductor switch associated with the inductor to close. In this way, the energy of the energy accumulator passes through the inductor and is received by the vehicle battery, returning to the energy accumulator, for example, through the (e.g., second) switching device that is arranged opposite to the inductor. Subsequently, the semiconductor switch controller may instruct the (e.g., first) semiconductor switch associated with the inductor to close. **In** this way, the energy of the energy accumulator does not pass through; instead, the inductor, which is charged according to the previous stage where the (e.g., first) switching device that is associated with the inductor was in the open position, provides energy to the vehicle battery, which may return to the inductor. Again, when the electric motor, or any other load that is supplied by the vehicle battery, is required to be supplied with electric power from the vehicle battery, the switching device controller prioritizes this action over the EIS measurements, and then instructs both (i.e., the first and second) switching devices to be in the closed position. When the electric motor is neither required to be supplied with electric power from the vehicle battery nor performing the EIS measurements, the switching device controller instructs both (i.e., the first and second) switching devices to be in the open position.

The semiconductor switch controller may be arranged in the junction box. Additionally, or alternatively, the semiconductor switch controller and the switching device controller may be integrated into an electronic control unit, preferably arranged in the junction box. It may be still possible that the semiconductor switch controller and/or the switching device controller is/are an integral part of the battery management system or BMS.

The energy modulator may preferably be arranged in the junction box. Instead, it is advantageous that the energy accumulator is arranged out of the junction box. Further, as previously discussed, the primary functionality of the junction box is to protect the integrity of the vehicle battery and other powertrain components, as well as to enable safe connection and disconnection of the vehicle battery. Positioning the energy modulator within the junction box is advantageous because it ensures accurate current measurement (at least when the excitation current signal is produced) at the output. This configuration helps to avoid or reduce the issue of a portion of the current of the excitation current signal being absorbed by a component of the system, such as the inverter filter or DC-link. By integrating the energy modulator inside the junction box, the excitation current signal generated is less affected e.g., by the disturbances or capacitive elements of the inverter filter. As a result, the integrity and accuracy of the excitation current signal are better preserved, enabling more reliable EIS measurements and battery characterization.

The above-mentioned current sensor may be attached to or be an integral part of the high-voltage electric circuit, for example, in the junction box. As explained above, the current sensor may be a single current sensor that senses the current of two or more modules of the vehicle battery.

It is preferred that the energy accumulator is or comprises at last one of the DC-link capacitor(s), the on-board charger system or OBC, a low-voltage converter, and a DC/DC converter. In other words, the DC-link capacitor(s), the on-board charger or OBC, the low-voltage converter, and/or the DC/DC converter may also act as the energy accumulator. For example, the term 'energy accumulator' may refer to any component or system configured to store electrical energy, either temporarily or over a longer duration, for purposes of providing electric power into the energy modulator. When implemented, the energy accumulator may comprise, or be embodied in, one or more of a DC-link capacitor or capacitors, the on-board charger (OBC), the low-voltage converter, or the DC/DC converter. While some of these components are not conventionally referred to as energy accumulators, they may include or be associated with energy storage elements (e.g., capacitors or intermediate storage stages) that perform energy accumulation functions within the context of enabling the excitation current signal.

The DC-link capacitor(s) may be configured at least to filter DC output of a motor inverter. For this, DC-link capacitor(s) may be arranged between the DC/DC converter and the motor inverter. The low-voltage converter may be configured to convert high-voltage DC (direct current) from the vehicle battery to low-voltage DC for the low voltage system. The DC/DC converter is an electronic device that converts direct current (DC) electrical power from a first voltage level to a second, different voltage level. The DC/DC converter, or step-down converter, may be configured to step down high voltage (e.g., above 400 V) from the vehicle battery to charge the (12V) low voltage system (e.g., lights, infotainment, power steering, electronic control units, and sensors).

The present system provides several technical advantages. In particular:
- It requires a reduced number of additional components, as the same battery current sensor may be utilized for both standard battery current monitoring and EIS (current) measurement;
- The (battery) junction box may be positioned in proximity to both the vehicle battery and the Battery Management System (BMS), thereby reducing the required harness length and associated energy losses;
- The integration of the system within the (battery) junction box may be configured to exhibit minimal thermal losses, as it can be thermally coupled to the battery contact plate or battery refrigeration system;
- The system is designed for ease of maintenance, wherein replacement may be performed by substituting only the (battery) junction box;
- The energy accumulator is arranged within the vehicle powertrain system architecture, thereby obviating the need for external elements or additional housing outside the vehicle structure.

According to an aspect of the present invention, it is proposed a method of operating an electrochemical impedance spectroscopy system. The method may be used for determining an electrochemical impedance of a vehicle battery. The method comprises:
- providing a vehicle battery comprising a first battery module that includes a plurality of battery cells, and, optionally, providing a second battery module that includes a plurality of battery cells;
- electrically connecting a battery management system to the vehicle battery;
- forming an electric circuit by electrically connecting the first module and an excitation power module;
- electrically connecting the second module to the electric circuit;
- sensing, by the current sensor, electric current of the electric circuit;
- electrically connecting the excitation power module to the battery management system;
- powering the excitation power module configured to excite the electric circuit;
- receiving, by the battery management system, the electric current of the electric circuit sensed by the current sensor;
- sensing or determining voltage of the plurality of battery cells of the first battery module by the battery management system;
- optionally, sensing or determining voltage of the plurality of battery cells of the second battery module by the battery management system;
- determining, by the battery management system, the impedance of the plurality of battery cells of the first battery module (and optionally of the second battery module) based at least on the electric current and the voltage, or
sending, by the battery management system, the electric current and the voltage to an external controller configured to determine the impedance of the plurality of battery cells of the first battery module (and optionally the second battery module) based at least on the electric current and the voltage.

The method may further comprise:
- receiving a vehicle input signal, wherein the vehicle input signal is at least related to vehicle status and the vehicle-battery status;
- determining a trigger command of the system based at least on the vehicle input signal;
- preferably, receiving or generating a starting instruction, wherein the trigger command of the system is further based on the starting instruction, optionally, the starting instruction is based at least in a pre-defined event, for example, on one of
   ∘ a predefined time,
   ∘ predefined distance, and
   ∘ an instruction from the user or driver.

The method may further comprise:
- opening a first switching device. If a second switching device is further provided, then preferably closing the second switching device. Optionally the first switching device is open at least in an instant when the second switching device is closed;
- closing a first semiconductor switch in a first stage, wherein energy of an energy accumulator of the excitation power module passes through an inductor and is received by the vehicle battery. The energy may return to the energy accumulator, preferably through the second switching device; and
- opening the first semiconductor switch in a second stage, wherein energy of the energy accumulator does not pass through the first semiconductor switch, wherein the inductor provides energy to the vehicle battery. The energy may return to the inductor, for example, through a second semiconductor switch or a diode.

### BRIEF DESCRIPTION OF THE DRAWINGS

Non-limiting examples of the present disclosure will be described in the following, with reference to the appended drawings.

In the drawings:
Figure 1 is a schematic illustration of an electrochemical impedance spectroscopy system connected to an external controller, and a junction box, wherein the junction box is further connected to an electric power operated system;
Figure 2 is a schematic illustration similar to figure 1 showing an excitation input signal generated by the excitation power module as well as the electric current measured by the single-unit current sensor;

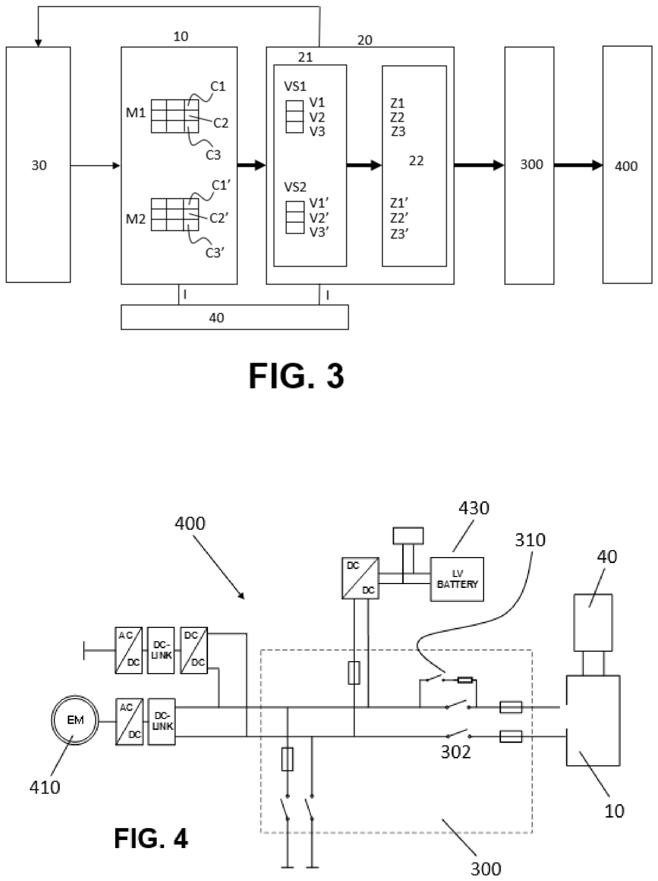

Figure 3 is a schematic illustration that shows the electrochemical impedance spectroscopy system without the vehicle battery;
Figure 4 is an overview illustration that shows the electrochemical impedance spectroscopy system implemented in a vehicle scenario;
Figure 5 is a schematic illustration showing that the battery management system, the single-unit current sensor, and the excitation power module form an electric circuit that is electrically independent of the high electric power flowing through the junction box and/or the electric power operated system. Figure 5 further illustrates a possible vehicle implementation where the external controller is connected to the electric circuit that is connected to the vehicle battery that is connected to the junction box that is connected to the electric power operated system;
Figure 6 is a schematic illustration of an excitation power module comprising an energy accumulator arranged outside a junction box, and an energy modulator arranged within the junction box, the energy modulator comprising a first branch, and a second branch;
Figure 7 is a schematic illustration similar to figure 6, further showing that the energy modulator includes a first semiconductor switch associated with the first branch, and an inductor associated with the second branch;
Figure 8 is a schematic illustration similar to figure 7, further showing a first anti-series semiconductor switch connected in series with the first semiconductor switch;
Figure 9 is a schematic illustration similar to figure 7, further showing that the energy modulator comprises a diode being associated with a third branch;
Figure 10 is a schematic illustration similar to figure 9, wherein figure 10 particularly shows that, instead of the diode, a second semiconductor switch is associated with the third branch;
Figure 11 is a schematic illustration similar to figure 10, further showing a second anti-series semiconductor switch connected in series with the second semiconductor switch; and
Figure 12 is a schematic illustration showing the energy modulator comprising at least a four-quadrant topology of semiconductor switches, such as a full-bridge configuration of MOSFETs.

### DETAILED DESCRIPTION OF EXAMPLES

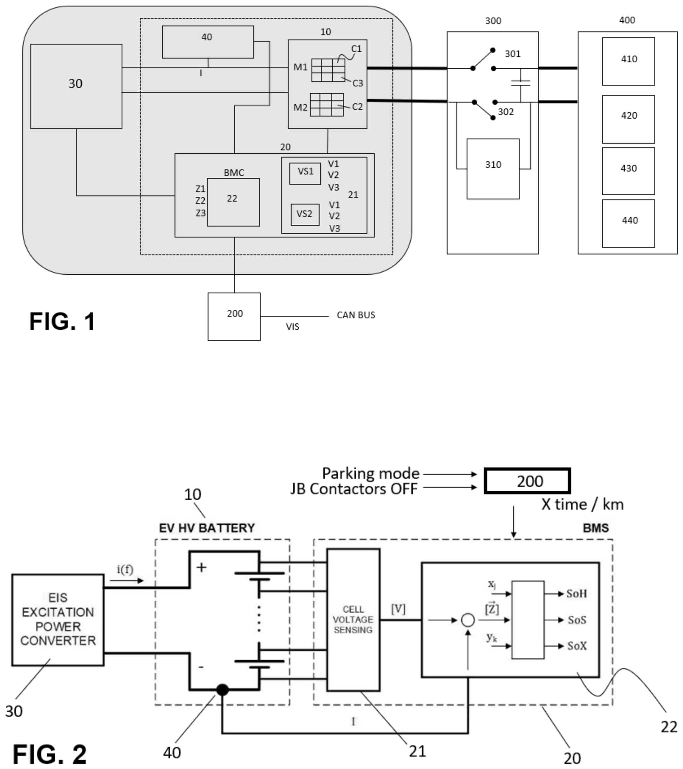

Figure 1 illustrates an electrochemical impedance spectroscopy system connected to an external controller 200 and a junction box 300. In turn, the junction box 300 is connected to an electric power operated system 400. The electrochemical impedance spectroscopy system is referred hereinafter as the system for clarity and conciseness reasons.

In the non-limiting example of figure 1, the electric power operated system 400 comprises different sub-systems such as a traction system 410, an air conditioning system 420, a low voltage system 430, and an on-board charger system 440 or OBC.

The junction box 300 is a vehicle junction box. The junction box 300 comprises contactors 301, 302 and/or relays to connect a vehicle battery 10 with the electric power operated system 400. When the contactors 301, 302 are open, the vehicle battery 10 and the electric power operated system 400 are in electrical isolation. When the contactors 301, 302 are closed, the vehicle battery 10 and the electric power operated system 400 are in electrical connection.

The external controller 200 is, in particular, a vehicle controller VCU such as a vehicle control unit. It is connected to a vehicle bus communication channel such as a CAN-bus. The external controller 200 may obtain a signal from a vehicle bus communication channel, with the CAN-bus being an example. The signal may include at least data related to a parking mode (or other vehicle modes such driving mode). If parking mode is selected, the contactors or relays of the junction box are open. If the driving mode is selected, contactors or relays of the junction box are closed.

As shown, the electrochemical impedance spectroscopy system comprises an EIS excitation power module 30, a vehicle battery 10, a battery management system 20 or BMS, and a current sensor 40.

Figure 1 shows that the vehicle battery 10 comprises two or more battery modules M1, M2. Each battery module M1, M2 includes a plurality of battery cells C1, C2, C3 (in the shown example C1, C2, C3 refer to a group of battery cells).

The battery management system (BMS) 20 is configured to control the vehicle battery 10, e.g., the two or more battery modules M1, M2. In particular, the battery management system (BMS) 20 is configured to perform cell balancing of the vehicle battery 10, e.g., the two or more battery modules M1, M2, at least derived in part from voltage measurements of the voltage sensor (explained below).

More in particular, the battery management system (BMS) 20 comprises a cell monitoring controller (CMC) 21 and a battery monitoring controller (BMC) 22. The cell monitoring controller (CMC) 21 includes a voltage sensor configured to sense or determine voltage of the two or more battery modules M1, M2. In fact, the voltage sensor comprises a plurality of voltage sensing devices VS1, VS2, each voltage sensing device VS1, VS2 being configured to sense or determine voltage V1, V2, V3 of the plurality of battery cells C1, C2, C3 of the two or more battery modules M1, M2. Also, the cell monitoring controller (CMC) 21 is further configured to perform the cell balancing. Furthermore, the battery monitoring controller (BMC) 22 includes a main (micro)controller which runs algorithms and performs calculations (e.g., the electrochemical impedance spectroscopy).

In examples, the excitation power module 30 is a single excitation power module. The excitation power module 30 is electrically connected to the vehicle battery 10, and the battery management system (BMS) 20. Also, the excitation power module 30 is configured to excite at least two or more battery modules M1, M2. The battery management system (BMS) 20 is particularly configured to instruct or control the excitation power module 30 for generating an excitation input signal. In particular, figure 1 illustrates that the excitation power module 30 is arranged out of an electric circuit involving high electric power, for example, the vehicle battery 10, the junction box 300, and the traction system 410.

As particularly shown in figure 2, the current sensor 40 is (electrically) connected to the two or more battery modules M1, M2. For example, it may be connected directly, such as via a shunt resistor, or indirectly, such as via a Hall sensor. In this way, the current sensor 40 is configured to sense at least electric current (I) of the two or more battery modules M1, M2, particularly, all the battery modules of the vehicle battery 10. Furthermore, the current sensor 40 is electrically connected to the battery management system (BMS) 20. The battery management system (BMS) 20 is thus configured to receive the electric current (I) of the two or more battery modules M1, M2 sensed by the current sensor 40.

In examples, the current sensor 40 is a single-unit current sensor. In particular, the current sensor 40 is electrically connected therebetween the EIS excitation power module 30 and the vehicle battery 10. It is absolutely possible that the current sensor 40 is arranged in the excitation power module 30, or in the vehicle battery 10, or in the junction box 300. As shown, an electric connecting means electrically connects the EIS excitation power module 30 and the vehicle battery 10 to each other. The electric connecting means includes two electric cables or wires, for example, a positive and a negative. The current sensor 40 is (directly) connected to electric connecting means or conductors.

The battery management system (BMS) 20 is configured to determine the impedance Z1, Z2, Z3, Z1', Z2', Z3' of the plurality of battery cells C1, C2, C3, C1', C2', C3' of the two or more battery modules M1, M2 based at least on the electric current I and the voltages V1, V2, V3, V1', V2', V3'. Alternatively, the battery management system (BMS) 20 is configured to send the electric current I and the voltages V1, V2, V3, V1', V2', V3' to the external controller 200 configured to determine the impedance Z1, Z2, Z3, Z1', Z2', Z3' of the plurality of battery cells C1, C2, C3, C1', C2', C3' of the two or more battery modules M1, M2 based at least on the electric current I and the voltages V1, V2, V3, V1', V2', V3'.

The battery management system (BMS) 20 or the external controller 200 is configured to determine the electrochemical impedance Z of the vehicle battery 10 (e.g., Z1, Z2, Z3 of the battery cells C1, C2, C3). Particularly, the electrochemical impedance's magnitude and phase is determined by applying Ohm's Law inputting the electric current I and voltages V1, V2, V3 of the vehicle battery cells C1, C2, C3. The determination of the electrochemical impedance Z is conducted under a potentiostatic mode (i.e., applying a constant direct-current potential with a superimposed alternate-current / sine-wave perturbation) or a galvanostatic mode (i.e., applying a constant current with a small non-constant current perturbation).

The battery management system (BMS) 20 or the external controller 200 is further configured to monitor an electrochemical degradation of the battery cells C1, C2, C3 by determining the impedance variation compared to one or more previous measurements of the battery cells C1, C2, C3 (that may include measurements that are performed in the factory or based on previous aging tests). For determining the impedance Z, the battery management system (BMS) 20 or the external controller 200 requires to study a frequency spectra analysis of the impedance Z so as to determine the resistance / reactance value(s) of the battery cells C1, C2, C3. In examples, the EIS excitation power module 30 generates voltage and current signals to the vehicle battery 10 within a frequency range of 0.1 - 4000 Hz. Said voltage and current signals are part of the excitation input signal i(f) that, in examples, comprises a sine-wave or square-wave. Other types of waves are of course possible as long as the excitation input signal i(f) includes perturbations. Then, based on the impedance Z measurements, an impedance curve is obtained, allowing the deduction of an equivalent circuit model (ECM) of the vehicle battery 10 (e.g., of the plurality of battery cells C1, C2, C2). This enables understanding how it has changed or degraded.

The excitation input signal i(f) is generated at cell-level scale, with a single excitation signal for each cell C1, C2, C3 or, alternatively, a single excitation input signal i(f) is generated for multiple cells C1, C2, C3 connected in parallel and/or series groups. The perturbation response (voltage or current) is measured at cell-level C1, C2, C3 to have a successful characterization of the battery cell impedance Z. Alternatively, the perturbation is obtained for multiple cells C1, C2, C3 with one measurement but the precision of the result will decrease. In non-limiting examples, the measured signals go to an analog-to-digital interface to be then processed to calculate the impedance Z. In any case, the excitation input signal i(f) through the battery cells C1, C2, C3 is small enough to not modify the battery cell conditions, alike the state of charge.

The battery management system (BMS) 20 is thus configured to receive or determine voltage and current measurements from the plurality of voltage sensors VS1, VS2 and the current sensor 40 respectively. Then, it is possible for the battery management system (BMS) 20 or the external controller 200 to process said measurements to determine the status of the vehicle battery 10. The battery management system (BMS) 20 or the external controller 200 is also configured to control the contactors 301, 302 of the junction box 300.

In non-limiting examples, the battery management system (BMS) 20 is configured to receive additional measurements of the vehicle battery 10 such as temperature, gas (e.g., H2, CO, CO2), pressure, isolation and leakage. The battery management system (BMS) 20 processes these values which can be transmitted to the external controller 200 through the vehicle bus communication channel, or could be used for internal use.

In examples, tracking the impedance status can be used to enhance the SoH and SoS.

The EIS performs a frequency analysis based on Ohm's Law using voltage and current measurements. EIS can be performed under potentiostatic mode if a voltage excitation input signal is generated at the battery cell level C1, C2, C3 and the current response at the battery modules level M1, M2 is measured. Alternatively, the galvanostatic mode uses a current excitation input signal, and the perturbation is the voltage drop at the cell C1, C2, C3. EIS analysis requires stable conditions for the vehicle battery 10; consequently, the most preferred mode is galvanostatic, as it does not impact the SoC or the temperature of the battery cells C1, C2, C3. EIS should report the impedance curve as a function of frequency for the battery cells C1, C2, C3. The frequency range to be analyzed is of between 0.1 Hz and 1 kHz. However, for practical application, a small number of frequencies (5 to 10) is sufficient to study the evolution of the impedance Z throughout the vehicle battery's lifespan.

To perform galvanostatic EIS, a controlled power module acts as a current source and directly connected to the vehicle battery 10. As illustrated, the system is an independent circuit from the electric power operated system 400. Therefore, the operation of the EIS excitation power module 30 is only possible when the electric power operated system 400 is disconnected from the vehicle battery 10.

As shown in figure 2, the excitation input (EIS current) signal i(f) to the vehicle battery 10 is sensed by the current sensor 40 that reports the signal I to the BMS controller. The battery 10 is composed of different modules M1, M2 where independent voltage measurements for each cell C1, C2, C3 report the voltage response V1, V2, V3 to the BMS controller. Then, the voltage values V1, V2, V3 and the current I are used to calculate the impedance at the cell level Z1, Z2, Z3. These impedance results are then used in algorithms in the BMS or another controller to determine the SoX value and enhance vehicle operation.

EIS is not (essentially) a recurrent analysis, as battery degradation is not abrupt. The test may be performed periodically or when requested by the user or driver or due to an event. Thus, the vehicle controller (BMS) 200 (or the BMC 22) creates a trigger command by itself after a predefined distance, a predefined time, or upon driver instruction. The command is transmitted to the battery management system (BMS) 20 through the vehicle bus communication channel. The BMS 20 registers the request and checks the vehicle status. As noted, EIS must be performed under stable conditions. Consequently, the vehicle has to be stopped, in parking mode, with no connection between the vehicle battery 10 and the motor drivers or charging buses. If the vehicle battery 10 is isolated from the electric power operated system 400 (e.g., the powertrain 410), the BMS 20 sends a wake-up command to the EIS converter controller. The EIS excitation power module 30 is configured with internal predefined parameters, or the BMS 20 commands them. Then, the EIS is performed, with the excitation input current i(f) reported to the BMS 20 (see figure 2), and the voltage perturbations sensed by the CMC 21. Once the EIS is finished, the BMS 20 sends another command to the EIS excitation power module 30 to stop and enter to sleep mode again. Finally, once the impedance data is processed, the predefined distance or timer counters in the external controller 200 (or BMC 22) are reset.

According to Kramers-Kroning conditions, the system may be ensured causal and physically consistent, where for the EIS the main conditions are: Causality, Linearity and Stability. The stability and linearity of the battery cells C1, C2, C3 can be better ensured under galvanostatic analysis, as a small potential perturbation through the battery cells C1, C2, C3 can result in a notable current perturbation response that can influence the battery cell conditions, like state of charge modification, which is a non-stable and non-linear response.

In examples, the battery management system (BMS) 20 is further configured to receive or generate a starting instruction. The starting instruction is based at least on one of a predefined time, predefined distance, and an instruction from the user or driver. For example, the predefined time may be 1 year, and the predefined distance may be 100,000 kilometers. Other times and distances may be of course possible.

The above-mentioned trigger command of the system is further based on the starting instruction. The battery management system (BMS) 20 is configured to receive a vehicle input signal VIS. In particular, the battery management system (BMS) 20 is configured to determine the trigger command based at least on the vehicle input signal VIS. Said vehicle input signal VIS is at least related to the vehicle status and the vehicle-battery status. The vehicle status is at least one of parking mode, ignition off, vehicle not started. The vehicle status serves the purpose of determining whether the vehicle battery receives and/or supplies electric power or not.

In non-limiting examples, the trigger command is further delayed by the pre-set time or up to the temperature of the vehicle battery 10 is lower than a pre-established temperature. Even more in particular, the trigger command is delayed up to the cell balancing is completed.

In any case, the vehicle input signal VIS is received from the external controller 200 or through a vehicle bus communication channel. In examples, the external controller 200 is arranged out of the electrochemical impedance spectroscopy system. Particularly, the battery management system (BMS) 20 or the external controller 200 is configured to receive a change of the vehicle-battery status SOX or the vehicle status. In use, the battery management system (BMS) 20 or the external controller 200 is configured to stop determining the impedance Z1, Z2, Z3 based on the change of the vehicle-battery status or the vehicle status.

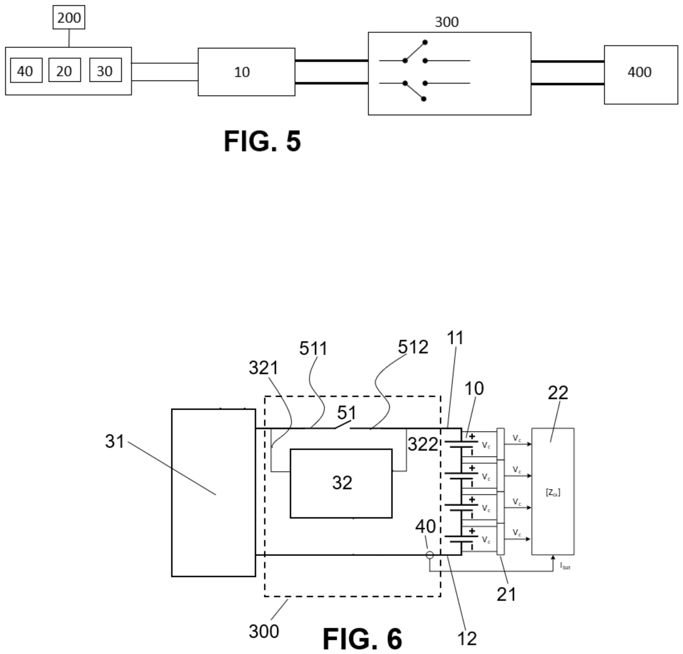

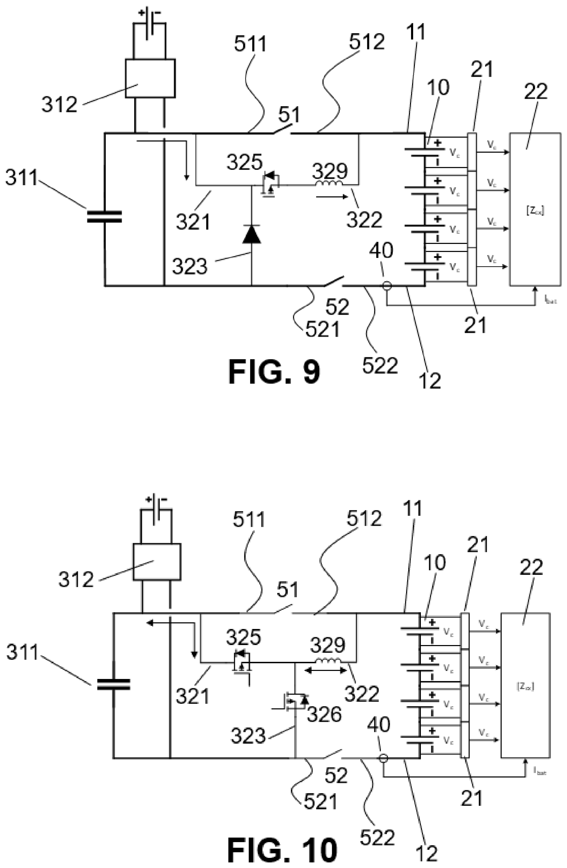

Figures 6-12 show a vehicle battery system comprising the electrochemical impedance spectroscopy system as described herein. The vehicle battery system may also comprise the junction box 300, and/or the DC-link 311, and/or the OBC 440 (see figure 1), and/or a low-voltage converter 312 (see figures 9-12), and/or a DC/DC converter (not shown). The vehicle battery system may provide electric power to a motor inverter (not shown). The motor inverter is operable to convert the DC power supplied by the battery system into AC power, which is used to drive an electric motor. The electric motor, in turn, provides the mechanical torque required to propel the wheels of an electric or hybrid vehicle, such as a passenger car.

The DC-link capacitors 311 are configured at least to filter DC output of the motor inverter. For this, DC-link capacitors 311 are arranged between the DC/DC converter and the motor inverter. The low-voltage converter 312 is configured to convert high-voltage DC from the vehicle battery 10 to low-voltage DC for the low voltage system 430. The DC/DC converter is an electronic device that converts direct current (DC) electrical power from a first voltage level to a second, different voltage level. The DC/DC converter is configured to step down high voltage, e.g., above 400V, from the vehicle battery 10 to charge the low voltage system 430, e.g., lights, infotainment, power steering, electronic control units, and sensors. The low voltage system 430 operates between 5 to 25 V.

Figure 6-12 show that the excitation power module comprises an energy accumulator 31, and an energy modulator 32. The energy modulator 32 is arranged within the junction box 300, whereas the energy accumulator 31 is arranged outside the junction box 300. Positioning the energy modulator 32 within the junction box 300 is advantageous because it improves accuracy of the current measurement of the current sensor 40 when operating the EIS system (i.e., when the excitation current signal is generated). It reduces the issue of part of the current of the excitation current signal being absorbed by a filter, for example, an inverter filter. This reduces the likelihood of a portion of the excitation current signal being absorbed by a filter, such as the inverter filter. By integrating the energy modulator 32 inside the junction box 300, the excitation current signal generated is less affected by the capacitive elements of the inverter (i.e., by disturbances related to the DC-link capacitors 311). As a result, a more reliable EIS system is achieved.

The energy accumulator 31 is configured to store electric power to be provided to the energy modulator 32. In use, the energy modulator 32 is configured to generate a variable excitation current signal to the vehicle battery 10.

As illustrated in figure 6-12, the excitation power module is electrically connected to the vehicle battery 10 by a first conductor 11 and a second conductor 12. The first and second conductors 11, 12 are connected to the terminals of the vehicle battery 10. The first conductor 11 is a busbar connected to the positive terminal of the vehicle battery 10, wherein the second conductor 12 is a busbar connected to the negative terminal of the vehicle battery 10.

Figures 6-12 show a first switching device 51 associated with the first conductor 11, e.g., to the positive terminal of the vehicle battery 10. Further, a second switching device 52 is associated with the second conductor 12, e.g., to the negative terminal of the vehicle battery 10. The second switching device 52 is optional rather than essential. If provided, it improves electrical isolation of the vehicle battery 10, e.g., when both the first and second switching devices 51, 52 are in the open position.

The first and second switching devices 51, 52 are configured to switch from an open position to a close position, and vice versa. The first and second switching devices 51, 52 are controlled, for switching purposes, by a switching device controller (not shown). In particular, the switching device controller is arranged within the junction box 300. For example, the first and second switching devices 51, 52 are electromechanical devices, such as contactors or relays, but other types of switching devices are of course possible such as electronic devices.

Figure 6 also illustrates that the energy modulator 32 comprises a first branch 321, a second branch 322, and, optionally, a third branch 323 (not shown in figure 6). As shown in figures 6 to 8, the third branch 323 is not provided, whereas it is provided in figures 9 to 12.

As shown, the first branch 321 is electrically connected to the second branch 322. When provided, the third branch 323 is electrically connected to the first and second branches 321, 322.

As illustrated in figures 6-12, the first switching device 51 defines a first side 511 and a second side 512. The first side 511 is arranged between the energy accumulator 31 and the first switching device 51, whereas the second side 512 is arranged between the first switching device 51 and the vehicle battery 10. Similarly, the second switching device 52 defines a first side 521 and a second side 522 (see figures 9 and 10 for the reference signs). The first side 521 of the second switching device 52 is arranged between the energy accumulator 31 and the second switching device 52, whereas the second side 522 is arranged between the second switching device 52 and the vehicle battery 10.

In examples, the first branch 321 is directly electrically connected to the first side 511 of the first switching device 51, whereas the second branch 322 is directly electrically connected to the second side 512 of the first switching device 51. In examples, the third branch 323 is directly electrically connected to the first side 521 of the second switching device 52. However, it is possible the third branch 323 to be directly connected to the second side 522 (not shown).

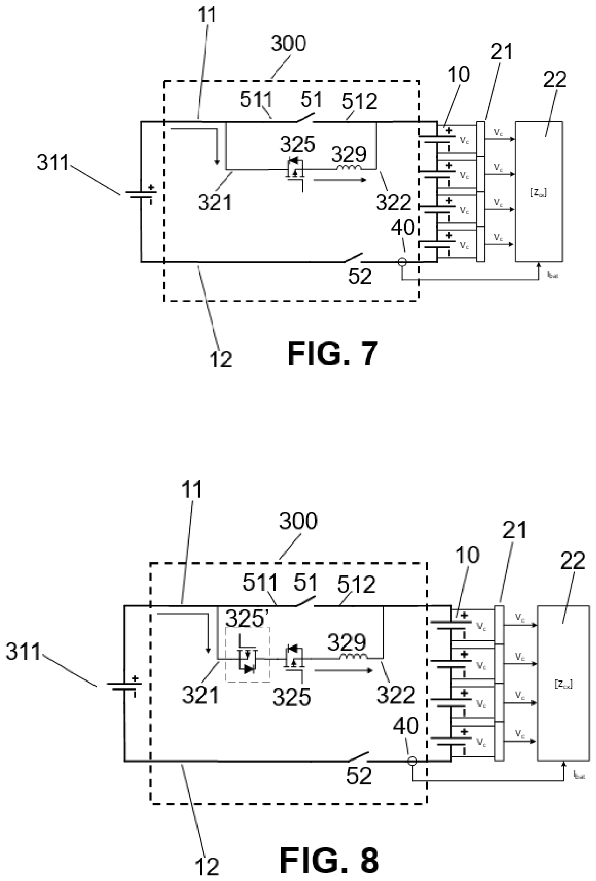

Figure 7 illustrates that the first branch 321 comprises a first semiconductor switch 325. For example, the first semiconductor switch 325 is a controllable transistor such as a MOSFET. The first semiconductor switches 325 is controlled via a PWM switching signal. The system further comprises a semiconductor switch controller (not shown) configured to control the open and closed positions of the first semiconductor switch 325 by the PWM switching signal. In particular, the semiconductor switch controller is arranged within the junction box 300. As the first semiconductor switch 325 can be controlled to open and close, the energy modulator 32 is capable of producing the variable excitation signal for enabling accurately EIS measurements.

Furthermore, the second branch 322 comprises an inductor 329. In use, the inductor 329 is configured to store energy in a magnetic field when electric current flows through it, while reducing voltage ripple, thereby ensuring a smoother and more stable power supply to the vehicle battery 10, which is particularly beneficial for enabling accurate EIS measurements. The inductor 329 is thus configured to receive electrical energy from a power supply external to the junction box 300. In examples, said power supply external to the junction box 300 is the DC-link capacitors 311, but instead, it is still possible from the OBC 440, the low-voltage converter 312, or the DC/DC converter. It is absolutely possible for the second branch to further include one or more capacitors and/or one or more additional inductors for this purpose. In this way, the one or more capacitors and/or the one or more additional inductors may be connected in association with the inductor 329 to form a filter, such as a resonant filter. Particularly, the inductor 329 is part of or attached to the junction box 300.

When the switching device controller instructs the first and second switching devices 51, 52 to be in the open position, the vehicle battery 10 does not supply electrical power. Instead, when the switching device controller instructs the first and second switching devices 51, 52 to be both in the closed position, the vehicle battery 10 supplies electrical power. When the switching device controller instructs the first switching devices 51 to be in the open position and the second switching device 52 to be in the closed position, the EIS system is generating the excitation current signal for the purposes of determining the impedance Z1, Z2 of the battery modules M1, M2. In particular, according to a first stage, the semiconductor switch controller instructs the first semiconductor switch 325 to close. In this way, the energy of the energy accumulator 31 passes through the inductor 329 and is received by the vehicle battery 10, returning to the energy accumulator 31, for example, through the second switching device 52. Subsequently, according to a second stage, the semiconductor switch controller instructs the first semiconductor switch 325 to open. In this way, the energy of the energy accumulator 31 does not pass through; instead, the inductor 329, which is charged in the first stage, provides energy to the vehicle battery 10.

In examples, the current sensor 40 is arranged within the junction box 300 for sensing electric current during the excitation current signal. Particularly, the current sensor 40 is arranged in the first conductor 11 or in the second conductor 12. More in particular, the current sensor 40 is arranged in the second side 512 of the first switching device 51, or in the second side 522 of the second switching device 52.

Figure 8 further shows a first anti-series semiconductor switch 325' connected in series with the first semiconductor switch 325. Therefore, the first branch 321 also comprises the first anti-series semiconductor switch 325'. As illustrated, the conduction path of the first anti-series semiconductor switch 325' is arranged in an opposite direction to the conduction path of the first semiconductor switch 325.

By enabling control over the open and closed states of the first anti-series semiconductor switch 325', it is possible to prevent short circuits in the vehicle battery 10. Further, electric current flows through in only one direction.

The first anti-series semiconductor switch 325' is in an open state when the EIS system is not in operation, thereby preventing revers current flow. Conversely, the first anti-series semiconductor switch 325' is in a closed state when the EIS system is in operation, thereby allowing bidirectional current flow. In this way, the first anti-series semiconductor switch 325' serves to prevent short circuits in the vehicle battery, and allows for safe disconnection of the EIS system in the event of an overcurrent condition, thereby mitigating the risk of damage to system components.

Figures 9 illustrate the third branch 323. The third branch 323 comprises a first end, and a second end. The first end is connected between the energy accumulator 31 and the first semiconductor switch 325. For example, when the anti-series semiconductor switch 325' is provided, the first end is directly connected between the anti-series semiconductor switch 325' and the first semiconductor switch 325 (not shown). The second end is connected to the second conductor 12. A diode is provided in the third branch 323 as a protection component, configured to prevent current peaks.

Figures 10 further shows that the third branch 323 comprises a second semiconductor switch 326. For example, the second semiconductor switch 326 is a controllable transistor, such as a MOSFET. The second semiconductor switches 326 is controlled via a PWM switching signal. The semiconductor switch controller is further configured to control the open and closed positions of the second semiconductor switch 326 by the PWM switching signal. As the second semiconductor switch 326 can be controlled to open and close, the energy modulator 32 is capable of producing the variable excitation current signal allowing an improved accuracy of the EIS measurements. In particular, the second semiconductor switch 326 is in the closed position when the first semiconductor switch 325 is in the open position, and vice versa, the second semiconductor switch 326 is in the open position when the first semiconductor switch 325 is in the closed position.

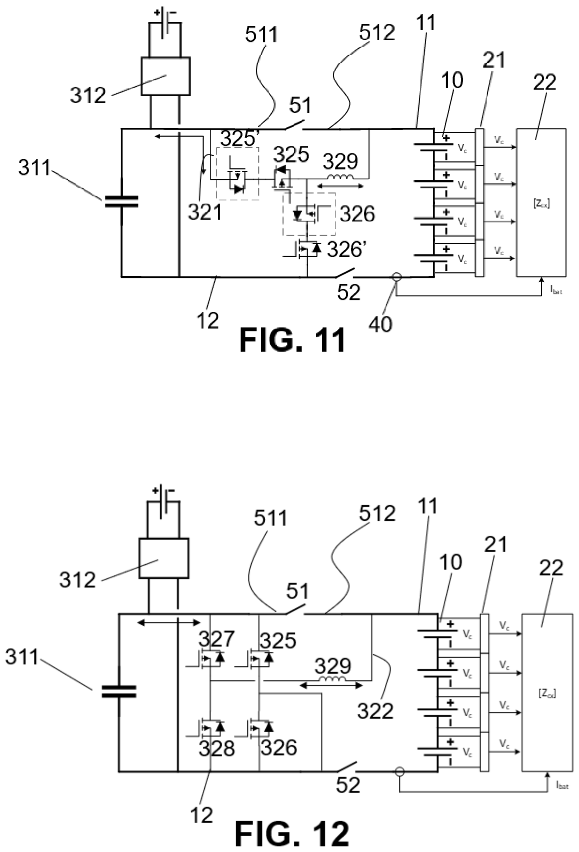

Figure 11 depicts that the first branch 321 comprises the first semiconductor switch 325 and the first anti-series semiconductor switch 325' (as previously explained in figure 8), and also the third branch 323 further comprises the second semiconductor switch 326 and the second anti-series semiconductor switch 326'. As illustrated, the conduction path of the second anti-series semiconductor switch 326' is arranged in an opposite direction to the conduction path of the second semiconductor switch 326. By enabling control over the open and closed states of the second anti-series semiconductor switch 326', it is possible to prevent short circuits in the vehicle battery 10. Further, electric current flows through in only one direction in the third branch 323. In particular, the second anti-series semiconductor switch 326' is in an open state when the EIS system is not in operation, thereby preventing revers current flow. Conversely, the second anti-series semiconductor switch 326' is in a closed state when the EIS system is in operation, thereby allowing bidirectional current flow. In this way, the first anti-series semiconductor switch 325' serves to prevent short circuits in the vehicle battery, and allows for safe disconnection of the EIS system in the event of an overcurrent condition, thereby mitigating the risk of damage to system components.

Figure 12 shows the energy modulator 32 comprising at least a four semiconductor switches 325, 326, 327, 328 arranged in two complementary pairs, e.g., a full-bridge configuration of MOSFETs. In operation, the semiconductor switch controller is configured to select / activate diagonal pairs of semiconductor switches 325, 326, 327, 328 in alternating patterns and adjusting at least the duty cycle of the switching signals. This configuration enables the creation of an alternating signal, e.g., bipolar PWM waveform, that may vary in amplitude, polarity, and frequency depending on the application requirements.

In either the two-quadrant topology, e.g., half bridge, or the four-quadrant topology, e.g., full-bridge, at least bidirectional current flow is enabled so as to modulate the excitation current signal for exciting (one,) two or more battery modules M1, M2. If the four-quadrant topology, e.g., full-bridge, is implemented, bidirectional voltage is further enabled.

The method for operating an electrochemical impedance spectroscopy system comprises the following steps:
Providing a vehicle battery 10 comprising a first battery module M1, and a second battery module M2. The first battery module M1 includes a plurality of battery cells C1, C2, C3. The second battery module M2 also includes a plurality of battery cells C1', C2', C3'.

Electrically connecting a battery management system (BMS) 20 to the vehicle battery 10. The battery management system (BMS) 20 comprises a cell monitoring controller (CMC) 21 and a battery monitoring controller (BMC) 22.

Forming an electric circuit by electrically connecting at least the first module M1, and an excitation power module 30. The electric circuit may not be a high-voltage electric circuit. Furthermore, the method includes electrically connecting the second module M2 to the electric circuit (i.e., the excitation power module 30, and the first and second modules M1, M2 form said electric circuit).

Electrically connecting the excitation power module 30 to the battery management system (BMS) 20.

Electrically connecting a current sensor 40 to the electric circuit.

Powering the excitation power module 30 configured to excite the electric circuit.

Sensing, by the current sensor 40, electric current I of the electric circuit at least when the electric circuit is being excited.

Receiving, by the battery management system (BMS) 20, the electric current I of the electric circuit sensed by the current sensor 40.

Sensing, determining, or receiving voltage V1, V2, V3 of the plurality of battery cells C1, C2, C3 of the first battery module M1 by the battery management system (BMS) 20.

Sensing, determining, or receiving voltage V1', V2', V3' of the plurality of battery cells C1', C2', C3' of the second battery module M2 by the battery management system (BMS) 20.

Determining the impedance Z1, Z2, Z3, Z1', Z2', Z3' of the plurality of battery cells C1, C2, C3, C1', C2', C3' of the first battery module M1 and the second battery module M2 based at least on the electric current I and the voltage V1, V2, V3, V1', V2', V3' by the battery management system (BMS) 20. Alternatively, it is absolutely possible that the method comprises sending the electric current I and the voltage V1, V2, V3, V1', V2', V3' to an external controller 200 configured to determine the impedance Z1, Z2, Z3, Z1', Z2', Z3' of the plurality of battery cells C1, C2, C3, C1', C2', C3' of the first battery module M1 and the second battery module M2 based at least on the electric current I and the voltage V1, V2, V3, V1', V2', V3'.

The method further comprises:
Receiving a vehicle input signal VIS. The vehicle input signal VIS is at least related to vehicle status and the battery pack status.

Determining a trigger command of the electrochemical impedance spectroscopy system based at least on the vehicle input signal VIS.

Receiving or generating a starting instruction. The trigger command of the electrochemical impedance spectroscopy system is further based on the starting instruction. The starting instruction is based at least on one of a predefined time, a predefined distance, and an instruction from a user or driver.

Connecting the vehicle battery 10, the junction box 300, and the electric power operated system 400 to each other forming a high-voltage electric circuit being different from the above-mentioned electric circuit. In addition, determining the impedance Z1, Z2, Z3, Z1', Z2', Z3' when the contactors 301, 302 and/or relays of the junction box 10 are in open position.

The method further comprises:
Opening the first switching device 51, and closing the second switching device 52 when provided. When the second switching device 52 is provided, the first switching device 51 is open at least in an instant when the second switching device 52 is closed.

Closing the first semiconductor switch 325 in the first stage. For example, the first semiconductor switch 325 is closed at least in an instant when the second semiconductor switch 326 is open. In this way, the energy of the energy accumulator 31 passes through the first semiconductor switch 325 and the inductor 329 and is received by the vehicle battery 10, returning to the energy accumulator 31 e.g., through the second switching device 52. In this first stage, the inductor 329 is being charged.

Opening the first semiconductor switch 325 in the second stage. For example, the first semiconductor switch 325 is open at least in an instant when the second semiconductor switch 326 is closed. In this way, the energy of the energy accumulator 31 does not pass through the first semiconductor switch 325. Instead, the inductor 329, which is charged in the first stage, provides energy to the vehicle battery 10, which may return to the inductor 329, for example, through the second semiconductor switch 326 or the diode explained in figure 9.

Preferably, repeating the closing and opening of the first semiconductor switch 325 and the second semiconductor switch 326 as explained above, i.e., the first and second stages. This operation is performed at high switching speeds in order to generate the desired variable excitation current signal. The PWM switching signal enables the precise and rapid switching required to achieve such high-frequency modulation.

Preferably, when the first anti-series semiconductor switch 325' is provided, closing the first anti-series semiconductor switch 325' during operation of the EIS system, thereby allowing (bidirectional) electric current (flow) to reach the first semiconductor switch 325. When the second anti-series semiconductor switch 326' is provided, closing the second anti-series semiconductor switch 326' during operation of the EIS system.

All possible combinations of the examples described herein are also thus covered. The scope of the present disclosure should not be limited by particular examples, but should be determined only by a fair reading of the claims that follow. If reference signs related to drawings are placed in parentheses in a claim, they are solely for attempting to increase the intelligibility of the claim, and shall not be construed as limiting the scope of the claim.

## Claims

1. An electrochemical impedance spectroscopy system comprising:
- a vehicle battery (10) comprising one, two or more battery modules (M1, M2), wherein each battery module (M1, M2) includes a plurality of battery cells (C1, C2, C3);
- a battery management system (20) electrically connected to the vehicle battery (10), wherein the battery management system (20) is configured to sense, determine, or receive voltage (V1, V2, V3) of the plurality of battery cells (C1, C2, C3) of the one, two or more battery modules (M1, M2), wherein the battery management system (20) is configured to control the vehicle battery (10);
- an excitation power module (30) electrically connected to the vehicle battery (10) and the battery management system (20), wherein the excitation power module (30) is configured to excite at least the one, two or more battery modules (M1, M2); and
- a current sensor (40) configured to sense at least electric current (I) of the one, two or more battery modules (M1, M2) when excited,
wherein the battery management system (20) is configured to receive the electric current (I) of the one, two or more battery modules (M1, M2) sensed by the current sensor (40), and
wherein the battery management system (20) is configured to determine the impedance (Z1, Z2, Z3) of the plurality of battery cells (C1, C2, C3) of the one, two or more battery modules (M1, M2) based at least on the electric current (I) and the voltage (V1, V2, V3), or
wherein the battery management system (20) is configured to send the electric current (I) and the voltage (V1, V2, V3) to an external controller (200) configured to determine the impedance (Z1, Z2, Z3) of the plurality of battery cells (C1, C2, C3) of the one, two or more battery modules (M1, M2) based at least on the electric current (I) and the voltage (V1, V2, V3).

2. The system of claim 1, wherein the excitation power module (30) comprises an energy accumulator (31), and an energy modulator (32), wherein the energy accumulator (31) is configured to store electric power to be provided to the energy modulator (32), and wherein the energy modulator (32) is configured to generate a variable excitation current signal to the vehicle battery (10), preferably the energy accumulator (31) is or comprises a DC-link capacitor (412), a low-voltage converter (312), a DC/DC converter, or an on-board charger system (440).

3. The system of claim 2, wherein it further comprises a first switching device (51) connected to the vehicle battery (10), the first switching device (51) being configured to switch between an open position to a close position, wherein the energy modulator (32) is associated with the first switching device (51), and wherein the first switching device (51) is in the open position during operation of the excitation power module (30).

4. The system of claim 3, wherein it further comprises a second switching device (52) connected to the vehicle battery (10), the second switching device (52) being configured to switch between an open position to a close position, wherein the energy modulator (32) is associated with the first switching device (51) and the second switching device (52), and wherein the first switching device (51) is in the open position and the second switching device (52) is in the closed position during operation of the excitation power module (30).

5. The system of claim 4, wherein when both the first switching device (51) and the second switching device (52) are open, the vehicle battery (10) is electrically isolated, wherein when both the first switching device (51) and the second switching device (52) are closed, the vehicle battery (10) supplies electric power, and during operation of the excitation power module, the first switching device (51) is in the open position, and the second switching device (52) is in the closed position.

6. The system of any of claims 3-5, wherein the excitation power module (30) and the vehicle battery (10) are electrically connected to each other through a first conductor (11) and a second conductor (12), in use, the first switching device (51) is connected to the first conductor (11), and preferably the second switching device (52) is connected to the second conductor (12).

7. The system of any of claims 3-6, wherein it further comprises a switching device controller configured to control the open and closed positions of the first switching device (51) and preferably the second switching device (52), optionally the switching device controller is arranged in the junction box (300), preferably the energy modulator (32) is arranged in the junction box (300), and wherein the energy accumulator (31) is preferably out of the junction box (300).

8. The system of any of claims 3-7, wherein the first switching devices (51) and/or the second switching device (52) is an electronic switching device or an electromechanical switching device such as a contactor or a relay.

9. The system of any of claims 3-8, wherein the first switching device (51) defines a first side (511) and a second side (512),
the first side (511) being arranged between the energy accumulator (31) and the first switching device (51), and the second side (512) being arranged between the first switching device (51) and the vehicle battery (10),
wherein the energy modulator (32) comprises a first branch (321), and a second branch (322), wherein the first branch (321) is electrically connected to the second branch (322), and
wherein the first branch (321) is electrically connected to the first side (511) of the first switching device (51), and the second branch (322) is electrically connected to the second side (512) of the first switching device (51),
preferably the energy modulator (32) comprises an inductor (329) associated with the second branch (322), and
more preferably the energy modulator (32) comprises a first semiconductor switch (325) associated with the first branch (321).

10. The system of claim 9, wherein the energy modulator (32) further comprises a third branch (323), the third branch (323) being electrically connected to the first and second branches (321, 322), and wherein the third branch (323) is electrically connected to either side (521, 522) of the second switching device (52), preferably the energy modulator (32) comprises a second semiconductor switch (326) associated with the third branch (323).

11. The system of any of claims 9-10, wherein the energy modulator (32) comprises a first anti-series semiconductor switch (325') associated with the first branch (321), being connected in series with the first semiconductor switch (325), with its conduction path arranged in an opposite direction to the conduction path of the first semiconductor switch (325).
.

12. The system of any of claims 10-11, wherein the energy modulator (32) comprises a second anti-series semiconductor switch (326') associated with the third branch (323), being connected in series with the second semiconductor switch (326), with its conduction path arranged in an opposite direction to the conduction path of the second semiconductor switch (326).

13. The system of any of claims 2-12, wherein the energy modulator (32) comprises at least a two-quadrant topology that includes the first and the second semiconductor switches (325, 326), in use, enabling at least bidirectional current flow so as to modulate the excitation current signal.

14. The system of any of claims 9-13, wherein it further comprises a semiconductor switch controller configured to control the open and closed positions of each semiconductor switch (325, 326, 327, 328, 325', 326'), preferably the semiconductor switch controller is arranged in the junction box (300), and optionally the semiconductor switch controller and the switching device controller are integrated into an electronic control unit, preferably arranged in the junction box (300).

15. A method of operating an electrochemical impedance spectroscopy system comprising:
- providing a vehicle battery (10) comprising a first battery module (M1) that includes a plurality of battery cells (C1, C2, C3);
- electrically connecting a battery management system (20) to the vehicle battery (10);
- forming an electric circuit by electrically connecting at least the first module (M1), and an excitation power module (30);
- electrically connecting the excitation power module (30) to the battery management system (20);
- electrically connecting a current sensor (40) to the electric circuit;
- powering the excitation power module (30) configured to excite the electric circuit;
- sensing, by the current sensor (40), electric current (I) of the electric circuit at least when the electric circuit is being excited;
- receiving, by the battery management system (20) the electric current (I) of the electric circuit sensed by the current sensor (40);
- sensing, determining, or receiving voltage (V1, V2, V3) of the plurality of battery cells (C1, C2, C3) of the first battery module (M1) by the battery management system (20); and
- determining the impedance (Z1, Z2, Z3) of the plurality of battery cells (C1, C2, C3) of the first battery module (M1) based at least on the electric current (I) and the voltage (V1, V2, V3), by the battery management system (20), or
sending the electric current (I) and the voltage (V1, V2, V3) to an external controller configured to determine the impedance (Z1, Z2, Z3) of the plurality of battery cells (C1, C2, C3) of the one, two or more battery modules (M1, M2) based at least on the electric current (I) and the voltage (V1, V2, V3).
preferably the method further comprises:
- opening a first switching device (51), and preferably closing a second switching device (52), optionally the first switching device (51) is open at least in an instant when the second switching device (52) is closed;
- closing a first semiconductor switch (325) in a first stage, wherein energy of an energy accumulator (31) of the excitation power module (30) passes through an inductor (329) and is received by the vehicle battery (10), returning to the energy accumulator (31) preferably through the second switching device (52); and
- opening the first semiconductor switch (325) in a second stage, wherein energy of the energy accumulator (31) does not pass through the first semiconductor switch (325), wherein the inductor (329) provides energy to the vehicle battery (10), for example, through a second semiconductor switch (326) or a diode.
